# EUROPEAN PATENT APPLICATION

(11) **EP 4 604 708 A1**
(43) Date of publication of application: **20.08.2025**
(21) Application number: 23877282.6
(22) Date of filing: 10.10.2023
(51) Int. Cl.: H10N 30/50, H10N 30/02, H10N 30/067, H10N 30/87

(54) **PIEZOELECTRIC ELEMENT**

(30) Priority: 14.10.2022 JP 2022165512
(71) Applicant: Kyocera Corporation, Kyoto-shi, Kyoto 612-8501 (JP)
(72) Inventor: TANAKA, Kazuki, Kyoto-shi, Kyoto 612-8501 (JP)
(74) Representative: Viering, Jentschura & Partner mbB Patent- und Rechtsanwälte
(86) International application number: PCT/JP2023/036764
(87) International publication number: WO 2024/080279

(57) **Abstract**

A piezoelectric element includes: a laminate body; an electrical conductor layer; an electrode plate; and a coating layer. The laminate body includes a plurality of piezoelectric bodies and a plurality of internal electrodes laminated. The electrical conductor layer is connected to the internal electrodes and is positioned along the laminate direction of the laminate body. The electrode plate is bonded to the electrical conductor layer via a bonding material having electrical conductivity and is positioned along the laminate direction of the laminate body. The coating layer covers the electrical conductor layer and the electrode plate. The electrode plate includes a plurality of slits extending in a direction intersecting the laminate direction. The piezoelectric element includes a first gap between the electrode plate, the electrical conductor layer, and the bonding material.

## Description

### TECHNICAL FIELD

The disclosed embodiments relate to a piezoelectric element.

### BACKGROUND OF INVENTION

A known piezoelectric element includes a laminate body with a plurality of piezoelectric bodies and a plurality of internal electrodes laminated, an electrical conductor layer located on the side surface of the laminate body and connected to the internal electrodes, and an electrode plate part of which in a width direction is bonded to the electrical conductor layer via an electrically conductive bonding material (see, for example, Patent Document 1). In a proposed structure of the piezoelectric element, the electrical conductor layer and the electrode plate are covered with a coating layer located on the side surface of the laminate body (see, for example, Patent Document 2).

### CITATION LIST

### PATENT LITERATURE

Patent Document 1: JP 2008-211054 A
Patent Document 2: JP 2006-41279 A

### SUMMARY

A piezoelectric element according to one aspect of an embodiment includes a laminate body, an electrical conductor layer, an electrode plate, and a coating layer. The laminate body includes a plurality of piezoelectric bodies and a plurality of internal electrodes laminated. The electrical conductor layer is connected to the internal electrodes and is positioned along the laminate direction of the laminate body. The electrode plate is bonded to the electrical conductor layer via an electrically conductive bonding material and is positioned along the laminate direction of the laminate body. The coating layer covers the electrical conductor layer and the electrode plate. The electrode plate includes a plurality of slits extending in a direction intersecting the laminate direction. The piezoelectric element includes a first gap between the electrode plate, the electrical conductor layer, and the bonding material.

### ADVANTAGEOUS EFFECT

One aspect of the embodiment allows the possibility of separation of the electrode plate covered with the coating layer to be reduced.

### BRIEF DESCRIPTION OF THE DRAWINGS

FIG. 1 is a perspective view illustrating an overall configuration of a piezoelectric element according to an embodiment.
FIG. 2 is an enlarged plan view illustrating an example of a configuration of an electrode plate and its surroundings according to the embodiment.
FIG. 3 is a cross-sectional view taken along line III-III illustrated in FIG. 2.
FIG. 4 is a cross-sectional view taken along line IV-IV illustrated in FIG. 2.
FIG. 5 is a cross-sectional view illustrating an example of a configuration of an electrode plate and its surroundings according to another embodiment 1.
FIG. 6 is a cross-sectional view illustrating an example of a configuration of an electrode plate and its surroundings according to the other embodiment 1.
FIG. 7 is a cross-sectional view illustrating an example of a configuration of an electrode plate and its surroundings according to another embodiment 2.
FIG. 8 is a cross-sectional view illustrating an example of a configuration of an electrode plate and its surroundings according to the other embodiment 2.
FIG. 9 is an enlarged plan view illustrating an example of a configuration of an electrode plate according to another embodiment 3.
FIG. 10 is an enlarged plan view illustrating an example of a configuration of an electrode plate according to another embodiment 4.
FIG. 11 is an enlarged plan view illustrating an example of a configuration of an electrode plate and its surroundings according to another embodiment 5.
FIG. 12 is a cross-sectional view taken along line XII-XII illustrated in FIG. 11.
FIG. 13 is a cross-sectional view taken along line XIII-XIII illustrated in FIG. 11.
FIG. 14 is a cross-sectional view illustrating an example of a configuration of an electrode plate and its surroundings according to another embodiment 6.
FIG. 15 is a cross-sectional view illustrating an example of a configuration of an electrode plate and its surroundings according to the other embodiment 6.
FIG. 16 is an enlarged plan view illustrating an example of a configuration of an electrode plate and its surroundings according to another embodiment 7.
FIG. 17 is a cross-sectional view taken along line XVII-XVII illustrated in FIG. 16.
FIG. 18 is a cross-sectional view illustrating an example of a configuration of an electrode plate and its surroundings according to another embodiment 8.
FIG. 19 is an enlarged plan view illustrating an example of a configuration of an electrode plate and its surroundings according to another embodiment 9.
FIG. 20 is a cross-sectional view taken along line XX-XX illustrated in FIG. 19.
FIG. 21 is a cross-sectional view illustrating an example of a configuration of the electrode plate and its surroundings according to another embodiment 10.
FIG. 22 is an enlarged plan view illustrating an example of a configuration of an electrode plate and its surroundings according to another embodiment 11.
FIG. 23 is a cross-sectional view illustrating an example of a configuration of an electrode plate and its surroundings according to another embodiment 12.

### DESCRIPTION OF EMBODIMENTS

An embodiment of a piezoelectric element disclosed in the present application will be described below with reference to the attached drawings. Note that the present disclosure is not limited by the following embodiment. It is noted that the drawings are schematic, and the relationship between the dimensions of each element and the ratio of each element may differ from the reality. Furthermore, even between the drawings, portions may be included having the relationship between the dimensions of each element, and the ratio of each element, differ.

### Overall Configuration of Piezoelectric Element

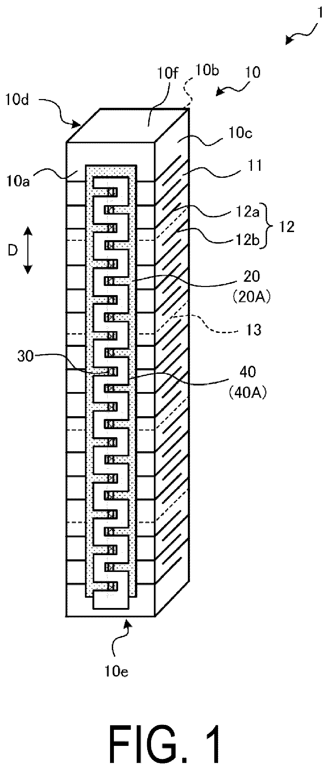

An overall configuration of a piezoelectric element 1 according to the embodiment will be described with reference to FIG. 1. FIG. 1 is a perspective view illustrating an overall configuration of the piezoelectric element 1 according to the embodiment.

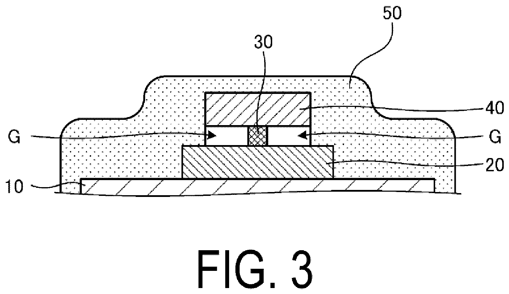

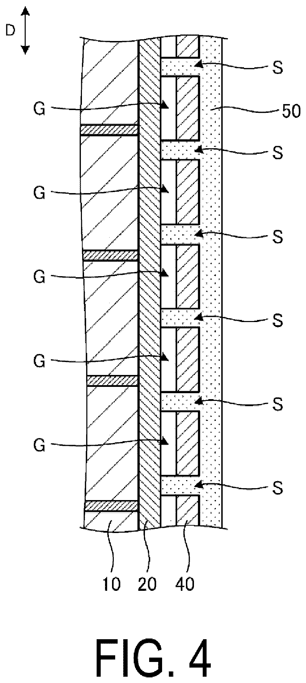

As illustrated in FIG. 1, the piezoelectric element 1 according to the embodiment includes a laminate body 10, a pair of electrical conductor layers 20, a pair of electrode plates 40, and a coating layer 50 (see FIGs. 3 and 4). The pair of electrical conductor layers 20 includes an electrical conductor layer 20A and an electrical conductor layer 20B, and the pair of electrode plates 40 includes an electrode plate 40A and an electrode plate 40B. In FIG. 1, the illustration of the coating layer 50, the electrical conductor layer 20B, and the electrode plate 40B is omitted for convenience of description.

The laminate body 10 has a pillar shape. The laminate body 10 has, for example, a quadrangular prism shape (rectangular parallelepiped shape) with a length of 0.5 mm to 10 mm, a width of 0.5 mm to 10 mm, and a height of 1 mm to 100 mm. Note that the shape of the laminate body 10 is not limited to a quadrangular prism but may be a hexagonal prism, an octagonal prism, or a cylinder.

The laminate body 10 includes a plurality of piezoelectric bodies 11, a plurality of internal electrodes 12, and a plurality of planned breaking layers 13. The laminate body 10 is composed by laminating the plurality of piezoelectric bodies 11, the plurality of internal electrodes 12, and the plurality of planned breaking layers 13 in a predetermined order along the laminate direction D. In the present disclosure, the laminate direction D of the laminate body 10 coincides with the longitudinal direction of the laminate body 10.

A piezoelectric body 11 is made of a piezoelectric material having piezoelectric properties, for example, piezoelectric ceramics. The material of the piezoelectric ceramics is, for example, a perovskite oxide composed of lead zirconate titanate (PbZrO₃-PbTiO₃), a lithium niobate (LiNbO₃), or a lithium tantalate (LiTaO₃).

The average particle diameter of the piezoelectric ceramics is, for example, 1.6 µm to 2.8 µm. The thickness of the piezoelectric body 11 is, for example, 3 µm to 250 µm.

The internal electrodes 12 are made of an electrically conductive material and include a plurality of first electrodes 12a and a plurality of second electrodes 12b. The first electrode 12a is electrically connected to the electrical conductor layer 20A arranged on one side surface 10a of the laminate body 10. A predetermined positive voltage is applied to the first electrode 12a via the electrical conductor layer 20A.

The second electrode 12b is electrically connected to an electrical conductor layer 20B arranged on the side surface 10b opposite to the side surface 10a of the laminate body 10. A predetermined negative voltage (or ground voltage) is applied to the second electrode 12b via the electrical conductor layer 20B.

Inside the laminate body 10, the first electrode 12a, the second electrode 12b and the piezoelectric body 11 are stacked such that the piezoelectric body 11 is arranged between the first electrode 12a and the second electrode 12b. This allows the laminate body 10 to apply a drive voltage to the piezoelectric body 11 by the first electrode 12a and the second electrode 12b.

The laminate body 10 according to the embodiment is composed of an active section composed by alternately laminating the plurality of piezoelectric bodies 11 and the plurality of internal electrodes 12 and an inactive section that is arranged at both ends in the laminate direction D in the active section and includes the piezoelectric bodies 11.

The active section is a site that extends or contracts (hereinafter also referred to as stretch) in the laminate direction D when a drive voltage is applied to the laminate body 10 from the outside. On the other hand, the inactive section is a site that does not stretch even when a drive voltage is applied to the laminate body 10 from the outside.

In the present disclosure, the lower end portion of FIG. 1 is a base end portion 10e of the laminate body 10, and the upper end portion of FIG. 1 is a front end portion 10f of the laminate body 10.

In the piezoelectric element 1 according to the embodiment, the base end portion 10e of the laminate body 10 is fixed, and the front end portion 10f of the laminate body 10 is displaced along the laminate direction D.

The material of the internal electrode 12 is, for example, a metal mainly composed of silver, silver-palladium, silver-platinum, or copper. The internal electrode 12 can be formed by, for example, co-firing with the piezoelectric body 11. The thickness of the internal electrode 12 is, for example, 0.1 µm to 5 µm.

The planned breaking layer 13 is a layer for relieving stress caused by driving the laminate body 10. Examples of the planned breaking layer 13 include a porous metal layer that does not function as the internal electrode 12 or a metal layer with a crack in advance. In the laminate body 10 according to the embodiment, the planned breaking layer 13 may be omitted.

As described above, the pair of electrical conductor layers 20 includes the electrical conductor layer 20A located on the side surface 10a of the laminate body 10 and an electrical conductor layer 20B located on the side surface 10b of the laminate body 10. The electrical conductor layer 20 is arranged over the entire active section of the laminate body 10. The electrical conductor layer 20 is located along the laminate direction D.

The material of the electrical conductor layer 20 is, for example, a metal composed mainly of silver or copper. For the electrical conductor layer 20, for example, a metallization layer made of the sintered body of the metal and glass can be used. The thickness of the electrical conductor layer 20 is, for example, 5 µm to 500 µm.

The pair of electrode plates 40 includes the electrode plate 40A and the electrode plate 40B and is electrically connected to the pair of electrical conductor layers 20 on a one-to-one basis. Specifically, the electrode plate 40A is electrically connected to the electrical conductor layer 20A, and the electrode plate 40B is electrically connected to the electrical conductor layer 20B.

The electrode plate 40 is located along the laminate direction D of the laminate body 10. A part of the electrode plate 40 in the width direction intersecting the laminate direction D is bonded to the electrical conductor layer 20 via an electrically conductive bonding material 30. The bonding material 30 is, for example, epoxy resin or polyimide resin containing metal powder having high electrical conductivity, such as Ag powder or Cu powder.

The material of the electrode plate 40 is, for example, a metal such as copper, iron, stainless steel, phosphor bronze. The width of the electrode plate 40 is, for example, 0.5 mm to 10 mm, and the thickness of the electrode plate 40 is, for example, 0.01 mm to 1.0 mm. To improve electrical and thermal conductivity, the surface of the electrode plate 40 may be coated with a plating film such as tin plating or silver plating.

The coating layer 50 is positioned on the entire circumference of the side surfaces including the side surfaces 10a and 10b of the laminate body 10 and covers the electrical conductor layer 20 and the electrode plate 40. Arranging the coating layer 50 on the side surfaces 10a and 10b allows surface discharge between both the electrodes that occurs in applying high voltage during driving to be reduced.

The coating layer 50 is made of, for example, an insulator. For example, fluorine-based resin, silicone resin, epoxy resin, nylon resin, or the like are used as the insulator to be the coating layer 50.

The coating layer 50 is positioned at least on the side surfaces 10a and 10b of the laminate body 10 so as to cover the electrical conductor layer 20 and the electrode plate 40 and is not necessarily be located on the entire circumference of the side surfaces. For example, the coating layer 50 may not be positioned on side surfaces 10c and 10d of the laminate body 10 but may be located only on the side surfaces 10a and 10b.

### Configuration of Electrode Plate and Coating Layer

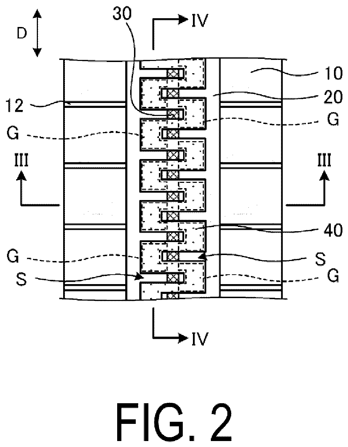

The detailed configuration of the electrode plate 40 and the coating layer 50 according to the embodiment will be described with reference to FIGs. 2 to 4. FIG. 2 is an enlarged plan view illustrating an example of the configuration of the electrode plate 40 and its surroundings according to the embodiment. FIG. 3 is a cross-sectional view taken along line III-III in FIG. 2. FIG. 4 is a sectional view taken along line IV-IV in FIG. 2. In FIG. 2, the illustration of the coating layer 50 is omitted for convenience of description.

As described above, the electrode plate 40 is a plate-like member extending in the laminate direction D of the laminate body 10, and a part of the electrode plate 40 in the width direction intersecting the laminate direction D is bonded to the electrical conductor layer 20 via an electrically conductive bonding material 30.

As illustrated in FIG. 2, in the embodiment, the electrode plate 40 includes a plurality of slits S. The slits S are cut so as to extend along the width direction (i.e., the direction intersecting the laminate direction D) of the electrode plate 40, for example.

The slits S are cut alternately from the end surfaces of both end portions of the electrode plate 40 positioned outside from the bonding material 30 in the width direction of the electrode plate 40 in a plan view and are arranged at substantially equal intervals along the laminate direction D. The plurality of slits S have substantially equal lengths. Note that the length of the slit S is the length in the notch direction of the slit S (i.e., the width direction of the electrode plate 40).

Furthermore, each length of the plurality of slits S is set so that the front end overlaps each other when viewed in the laminate direction D. "Overlap" means that the adjacent slits S have areas facing each other when viewed in the laminate direction D.

In the embodiment, arranging the plurality of slits S in the electrode plate 40 enables the electrode plate 40 to stretch in the laminate direction D following the stretch of the laminate body 10 in the laminate direction D. Therefore, the embodiment can reduce the possibility that the electrode plate 40 separates from the laminate body 10 or the electrical conductor layer 20.

On the other hand, the electrode plate 40 is covered together with the electrical conductor layer 20 by the coating layer 50 (see FIGs. 3 and 4) located on the side surfaces of the laminate body 10.

If the periphery of the electrode plate 40 and the electrical conductor layer 20 is completely covered with the coating layer 50, when the laminate body 10 stretches, a large stress that restricts the deformation of the electrode plate 40 is generated in the electrode plate 40. In particular, the stress that restricts the deformation of the twist is concentrated on the end portion of the electrode plate 40 positioned outside from the bonding material 30 in the width direction of the electrode plate 40 in a plan view. The stress that restricts the deformation is generated in the electrode plate 40 following the stretching of the laminate body 10, and the electrode plate 40 may thus separate from the laminate body 10 or the electrical conductor layer 20.

As illustrated in FIGs. 3 and 4, in the embodiment, the electrical conductor layer 20 and the electrode plate 40 are covered with the coating layer 50 with a gap G left between the end portions located outside the bonding material 30 in the width direction of the electrode plate 40 in a plan view and the electrical conductor layer 20. In other words, in the embodiment, the piezoelectric element 1 includes the gap G among the electrode plate 40, the electrical conductor layer 20, and the bonding material 30. A plurality of such gaps G are formed at positions that do not overlap the plurality of slits S of the electrode plate 40 in a plan view (see FIG. 2). The end portions positioned outside from the bonding material 30 in the width direction of the electrode plate 40 in a plan view is located facing the electrical conductor layer 20 across the gap G. The gap G is an example of a first gap.

In the embodiment, covering the electrical conductor layer 20 and the electrode plate 40 with the coating layer 50 with the gap G left causes deformation of the twist to occur at the end portions of the electrode plate 40 in the width direction following the stretch of the laminate body 10 in the laminate direction D, allowing the electrode plate 40 to be easily deformed. Thus, the embodiment can relax the stress generated in the electrode plate 40 due to the stretch of the laminate body 10, thereby reducing the possibility of separation of the electrode plate 40 from the laminate body 10 or the electrical conductor layer 20.

In the embodiment, as illustrated in FIGs. 2 and 3, a gap G between one end portion of the electrode plate 40 positioned outside from the bonding material 30 in a width direction of the electrode plate 40 in a plan view and the electrical conductor layer 20 is separated from a gap G between the other end portion of the electrode plate 40 and the electrical conductor layer 20. That is, the one gap G between one end portion of the electrode plate 40 and the electrical conductor layer 20, and the other gap G between the other end portion of the electrode plate 40 and the electrical conductor layer 20, are not connected and are closed individually with the bonding material 30 as a boundary. Separating the gap G at the one end portion and the gap G at the other end portion of the electrode plate 40 enables twist deformation to more easily occur at both ends of the electrode plate 40 in the width direction following the stretch of the laminate body 10 in the laminate direction D. Therefore, the embodiment can further relax the stress generated in the electrode plate 40 due to the stretch of the laminate body 10, thereby reducing the possibility of separation of the electrode plate 40 from the laminate body 10 or the electrical conductor layer 20.

In the embodiment, as illustrated in FIG. 2, one gap G between one end portion of the electrode plate 40 and the electrical conductor layer 20, and the other gap G between the other end portion of the electrode plate 40 and the electrical conductor layer 20, are disposed at positions that are mutually displaced in the laminate direction D of the laminate body 10. This enables the twist deformation to be more easily generated at both ends of the electrode plate 40 in the width direction, following the stretch of the laminate body 10 in the laminate direction D. Therefore, the embodiment can further relax the stress generated in the electrode plate 40 due to the stretch of the laminate body 10, thereby reducing the possibility of separation of the electrode plate 40 from the laminate body 10 or the electrical conductor layer 20.

In the embodiment, as illustrated in FIG. 2, the bonding material 30 may be positioned overlapping the center portion of the electrode plate 40 in a plan view. This results in that the gap G on one end side and the gap G on the other end side of the electrode plate 40 divided via the bonding material 30 can be substantially the same size. Thus, the twist deformation occurs equally at both ends of the electrode plate 40 in the width direction, following the stretch of the laminate body 10 in the laminate direction D. Accordingly, the embodiment allows the stress generated in the electrode plate 40 due to the stretch of the laminate body 10 to be equally relaxed at both ends of the electrode plate 40 in the width direction, thereby reducing the possibility of separation of the electrode plate 40 from the laminate body 10 or the electrical conductor layer 20.

In the embodiment, as illustrated in FIG. 2, the bonding material 30 may have a region overlapping the slit S of the electrode plate 40 in a plan view. This allows the electrode plate 40 to be difficult to separate from the bonding material 30 near the slit S of the electrode plate 40.

In the embodiment, the length of the slit S of the electrode plate 40 is larger than half the width of the electrode plate 40. This causes the position of the front end in the direction of the notch of the slit S, which is the origin of the twist generated at the end portion of the electrode plate 40 in the width direction, to be offset from the position of the bonding material 30 located at the center of the electrode plate 40. Thus, the electrode plate 40 is difficult to separate from the bonding material 30.

### Another Embodiment 1

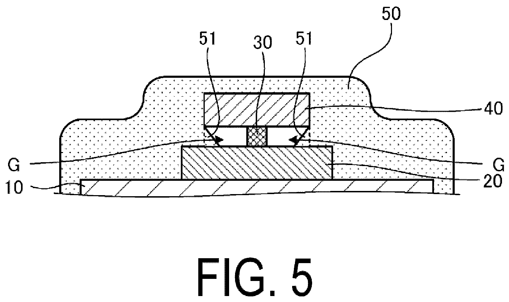

Other various embodiments will be described with reference to FIGs. 5 to 23. Note that in the following other various embodiments, portions that are the same as those in the embodiments will be denoted by the same reference signs, and redundant explanations may be omitted.

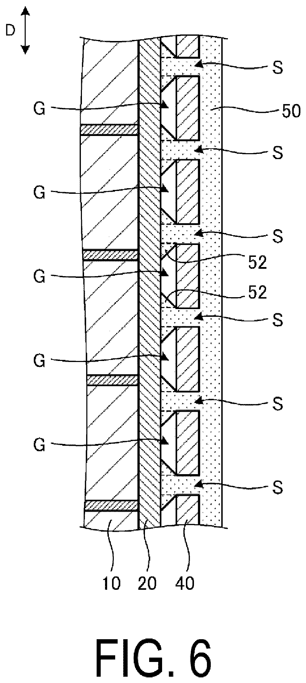

FIGs. 5 and 6 are cross-sectional views illustrating an example of the configuration of the electrode plate 40 and its surroundings according to the other embodiment 1. FIG. 5 corresponds to a cross-sectional view taken along line III-III illustrated in FIG. 2, and FIG. 6 corresponds to a cross-sectional view taken along line IV-IV illustrated in FIG. 2.

In the other embodiment 1 illustrated in FIGs. 5 and 6, the configuration of the coating layer 50 is different from the above embodiment. Specifically, in the other embodiment 1, as illustrated in FIG. 5, the coating layer 50 includes a protruding portion 51. The protruding portion 51 protrudes inward from the end portion of the electrode plate 40 in the direction intersecting the laminate direction D (i.e., the width direction) and contacts the electrical conductor layer 20. Here, "inward" means the side toward the center of the electrode plate 40. The protruding portion 51 is an example of a first protruding portion.

In the other embodiment 1, by providing the protruding portion 51 in the coating layer 50, the adhesion force between the coating layer 50 and the electrical conductor layer 20 is improved compared with the case with the protruding portion 51 not provided. Therefore, the adhesion force between the electrode plate 40 covered with the coating layer 50 and the electrical conductor layer 20 is improved. Therefore, the other embodiment 1 can reduce the possibility that the electrode plate 40 covered with the coating layer 50 separates from the electrical conductor layer 20.

In the other embodiment 1, as illustrated in FIG. 6, the coating layer 50 may include a protruding portion 52. The protruding portion 52 is positioned so as to project more inward than the inner wall surface of the slit S in the electrode plate 40 and contacts the electrical conductor layer 20. Here, "inward" means the side approaching the center of each electrode plate. The protruding portion 52 is an example of a second protruding portion.

By providing the protruding portion 52 in the coating layer 50, the adhesion force between the coating layer 50 and the electrical conductor layer 20 is improved compared with when the protruding portion 52 is not provided, so that the adhesion force between the electrode plate 40 covered with the coating layer 50 and the electrical conductor layer 20 is improved. Therefore, the other embodiment 1 can reduce the possibility that the electrode plate 40 covered with the coating layer 50 separates from the electrical conductor layer 20.

### Another Embodiment 2

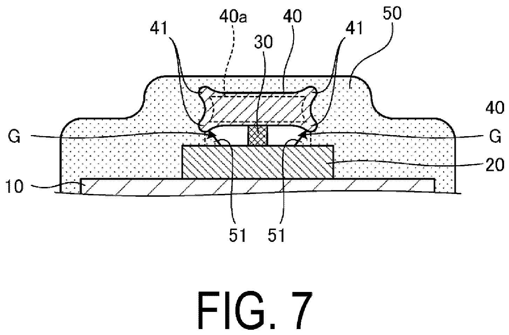

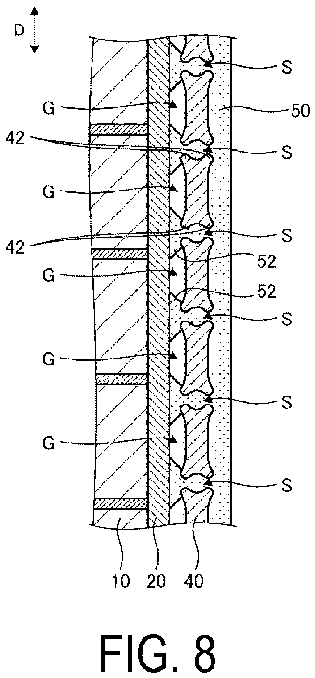

FIGs. 7 and 8 are cross-sectional views illustrating an example of the configuration of the electrode plate 40 and its surroundings according to the other embodiment 2. FIG. 7 corresponds to a cross-sectional view taken along line III-III illustrated in FIG. 2, and FIG. 8 corresponds to a cross-sectional view taken along line IV-IV illustrated in FIG. 2.

In the other embodiment 2 illustrated in FIGs. 7 and 8, the configuration of the electrode plate 40 is different from that of the other embodiment 2 described above. Specifically, in the other embodiment 2, as illustrated in FIG. 7, the electrode plate 40 includes a projecting portion 41 projecting in the thickness direction of the electrode plate 40 at the periphery of the end portion of the electrode plate 40 in the direction crossing the laminate direction D (i.e., the width direction). The projecting portion 41 is an example of a first projecting portion.

In the other embodiment 2, by providing the projecting portion 41 in the electrode plate 40, the strength of both end portions at the electrode plate 40 is increased compared with when the projecting portion 41 is not provided, so that damage to both ends of the electrode plate 40 caused by repeated deformation is less likely to occur. Therefore, the other embodiment 2 enables the durability of the electrode plate 40 to be improved. In FIG. 7, the projecting portion 41 is positioned on each of the side of the laminate body 10 and on the opposite side of the laminate body 10 but may be positioned only on the side of the laminate body 10.

In the other embodiment 2, the thickness of the protruding portion 51 of the coating layer 50 located near the projecting portion 41 is reduced by the thickness of the projecting portion 41, so that the electrode plate 40 can be easily deformed, following the stretch of the laminate body 10 in the laminate direction D. Therefore, the other embodiment 2 can further relax the stress generated in the electrode plate 40 due to the stretch of the laminate body 10, thereby reducing the possibility that the electrode plate 40 separates from the laminate body 10 or the electrical conductor layer 20.

In the other embodiment 2, the projecting portion 41 may extend along the laminate direction D of the laminate body 10. As a result, the strength of both end portions of the electrode plate 40 is increased, so that damage to both end portions of the electrode plate 40 caused by repeated deformation is less likely to occur. Therefore, the other embodiment 2 allows the durability of the electrode plate 40 to be further improved.

In the other embodiment 2, as illustrated in FIG. 8, the electrode plate 40 may include a projecting portion 42 projecting in the thickness direction of the electrode plate 40 at the periphery of the slit S in the electrode plate 40. The projecting portion 42 is an example of the second projecting portion.

By providing the projecting portion 42 in the electrode plate 40, the strength of the periphery of the slit S in the electrode plate 40 increases compared with when the projecting portion 42 is not provided, and thus, the damage of the periphery of the slit S in the electrode plate 40 due to repeated deformation is less likely to occur. Therefore, the other embodiment 2 enables the durability of the electrode plate 40 to be improved. In FIG. 8, the projecting portion 42 is positioned on each of the side of the laminate body 10 and on the opposite side of the laminate body 10 but may be positioned only on the side of the laminate body 10.

In the other embodiment 2, the thickness of the protruding portion 52 of the coating layer 50 located near the projecting portion 42 is reduced by the thickness of the projecting portion 42, so that the electrode plate 40 can be easily deformed, following the stretch of the laminate body 10 in the laminate direction D. Therefore, the other embodiment 2 can further relax the stress generated in the electrode plate 40 due to the stretch of the laminate body 10, thereby reducing the possibility that the electrode plate 40 separates from the laminate body 10 or the electrical conductor layer 20.

In the other embodiment 2, the projecting portion 42 may extend along the longitudinal direction of the slit S. As a result, the strength of the periphery of the slit S in the electrode plate 40 increased, so that the damage of the periphery of the slit S in the electrode plate 40 caused by repeated deformation is less likely to occur. Therefore, the other embodiment 2 allows the durability of the electrode plate 40 to be further improved.

The formation of the projecting portions 41 and 42 can be achieved by etching the side surface of a metal plate 40a (see FIG. 7), which is the base material of the electrode plate 40, to form a concave portion and then plating the corner portion located at the periphery of the concave portion thicker than other portions.

### Another Embodiment 3

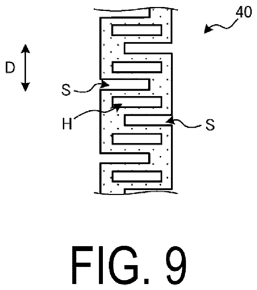

FIG. 9 is an enlarged plan view illustrating an example of the configuration of the electrode plate 40 according to the other embodiment 3. In the other embodiment 3 illustrated in FIG. 9, the shape of the electrode plate 40 is different from the above-described embodiments. Specifically, in the other embodiment 3, the electrode plate 40 includes a plurality of slits S and a plurality of through holes H.

The slits S are formed extending, for example, along the width direction (i.e., the direction intersecting the laminate direction D) of the electrode plate 40 to the end surface of either end portion of the electrode plate 40. The through holes H are formed extending along the same direction as those of the slits S but do not extend to the end surfaces of both the end portions of the electrode plate 40.

The plurality of slits S are alternately cut off from the end surfaces of both the end portions in the width direction of the electrode plate 40 and are arranged at substantially equal intervals along the laminate direction D. The plurality of slits S have substantially equal lengths. Each length of the plurality of slits S is set so that the front end overlaps each other when viewed in the laminate direction D.

In the other embodiment 3, arranging the plurality of slits S in the electrode plate 40 enables the electrode plate 40 to stretch in the laminate direction D, following the stretch of the laminate body 10 in the laminate direction D. Therefore, the other embodiment 3 can reduce the possibility that the electrode plate 40 separates from the laminate body 10 or the electrical conductor layer 20.

Furthermore, in the other embodiment 3, the through hole H is positioned between the slits S that are alternately cut off from the end surfaces of both the end portions in the width direction at the electrode plate 40. Such through hole H is arranged at a position that is equally spaced with respect to both adjacent slits S and has a length substantially equal to the length of the slit S.

That is, in the other embodiment 3, as illustrated in FIG. 9, in the electrode plate 40, the slit S extending from the end surface of one end portion, the through hole H, the slit S extending from the end surface of the other end portion, and the through hole H, are arranged in this order along the laminate direction D at substantially equal intervals.

In the other embodiment 3, the through hole H is arranged at a position where the front end of the slit S extending from one end surface of one end portion and the front end of the slit S extending from the other end surface of the other end portion overlap each other.

Thus, the stress generated between the slit S extending from one end surface of one end portion and the slit S extending from the other end surface of the other end portion can be dispersed, so that the stress generated in the electrode plate 40 due to the stretch of the laminate body 10 can be relaxed. Therefore, the other embodiment 3 can further reduce the possibility that the electrode plate 40 separates from the laminate body 10 or the electrical conductor layer 20.

### Another Embodiment 4

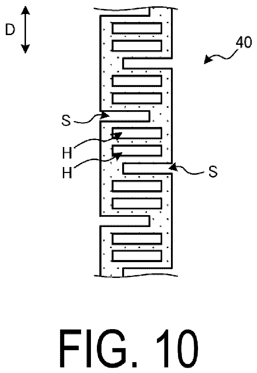

FIG. 10 is an enlarged plan view illustrating an example of the configuration of the electrode plate 40 according to the other embodiment 4. In the other embodiment 4 illustrated in FIG. 10, the arrangement of the through holes H is different from that in the other embodiment 3 described above.

Specifically, in the other embodiment 4, in the electrode plate 40, two or more through holes H are positioned adjacent to each other between the slits S that are alternately cut off from the end surfaces of both the end portions.

For example, as illustrated in FIG. 10, in the electrode plate 40, the slit S extending from the end surface of one end portion, the through hole H, the through hole H, and the slit S extending from the end surface of the other end portion, are arranged in this order along the laminate direction D at substantially equal intervals.

Thus, by arranging two or more through holes H adjacent to each other between the slits S alternately cut from both end surfaces in the width direction in the electrode plate 40, the stress generated in the electrode plate 40 due to the stretch of the laminate body 10 can be further relaxed. Therefore, the other embodiment 4 can further reduce the possibility that the electrode plate 40 separates from the laminate body 10 or the electrical conductor layer 20.

### Another Embodiment 5

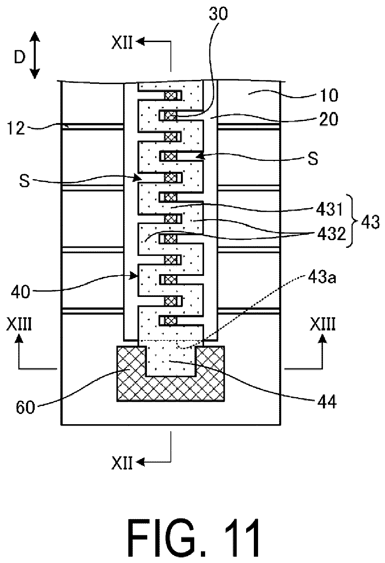

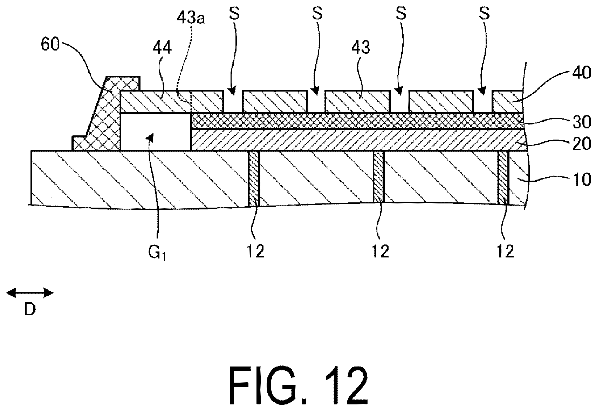

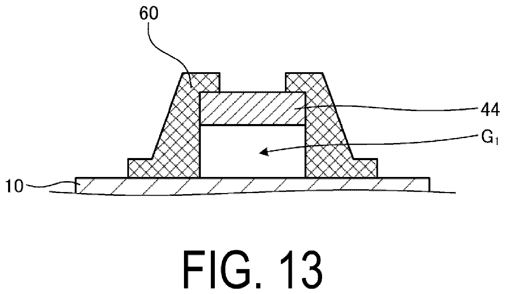

FIG. 11 is an enlarged plan view illustrating an example of the configuration of the electrode plate 40 and its surroundings according to the other embodiment 5. FIG. 12 is a cross-sectional view taken along line XII-XII illustrated in FIG. 11. FIG. 13 is a cross-sectional view taken along line XIII-XIII illustrated in FIG. 11. In FIGs. 11 to 13, the illustration of the coating layer 50 is omitted for convenience of description.

The other embodiment 5 illustrated in FIGs. 11 to 13 differs from the above embodiments in the configuration of the electrode plate 40 and in that a fixing material 60 are newly provided. Specifically, in the other embodiment 5, as illustrated in FIG. 11, the electrode plate 40 is a plate-like member extending in the laminate direction D of the laminate body 10 and includes a body portion 43 bonded to the electrical conductor layer 20 via an electrically conductive bonding material 30, and an extending portion 44 protruding from one end 43a of the body portion 43 in the laminate direction D and facing the laminate body 10.

The body portion 43 includes a first portion 431 in contact with the bonding material 30, and a second portion 432 positioned on both sides of the first portion 431 in the width direction (i.e., the direction intersecting the laminate direction D) and facing the electrical conductor layer 20 without contacting the bonding material 30.

As illustrated in FIG. 11, in the other embodiment 5, the body portion 43 of the electrode plate 40 includes a plurality of slits S. The slits S are cut so as to extend along the width direction (i.e., the direction intersecting the laminate direction D) of the body portion 43, for example.

The plurality of slits S are alternately cut from both sides (sides of the pair of second portions 432) of the body portion 43 and are arranged side by side at substantially equal intervals along the laminate direction D. The plurality of slits S have substantially equal lengths. Note that the length of the slit S is the length in the notch direction of the slit S ((i.e., the width direction of the body portion 43).

Furthermore, each length of the plurality of slits S is set so that the front end overlaps each other when viewed in the laminate direction D. "Overlap" means that the adjacent slits S have areas facing each other when viewed in the laminate direction D.

In the other embodiment 5, arranging the plurality of slits S in the body portion 43 of the electrode plate 40 enables the body portion 43 to stretch in the laminate direction D, following the stretch of the laminate body 10 in the laminate direction D. Therefore, the other embodiment 5 can reduce the possibility that the electrode plate 40 separates from the laminate body 10 or the electrical conductor layer 20.

The extending portion 44 of the electrode plate 40 faces the laminate body 10 across a first gap G₁.

The piezoelectric element 1 according to the other embodiment 5 includes the fixing material 60. The fixing material 60 fixes the electrode plate 40 and the laminate body 10. For example, the fixing material 60 fixes at least the extending portion 44 of the electrode plate 40 to the laminate body 10.

The fixing material 60 according to the other embodiment 5 may not necessarily fix the entire periphery of the extending portion 44 to the laminate body 10. That is, the fixing material 60 may only fix at least a part of the periphery of the extending portion 44 to the laminate body 10.

The fixing material 60 according to the other embodiment 5 may fix the entire periphery of the extending portion 44 to the laminate body 10 while a predetermined area surrounded by the periphery of the extending portion 44 is left in the extending portion 44. Thus, the predetermined region left in the extending portion 44 can be used as a region for connecting the lead terminal for supplying power to the electrode plate 40.

The fixing material 60 is made of, for example, an insulation material having thermal resistance and flexibility. As the insulation material to be the fixing material 60, for example, epoxy resin, glass, ceramics, or composite material of epoxy resin and ceramics can be used. When ceramics or composite material of epoxy resin and ceramics are used as the insulation material to be the fixing material 60, the material of the ceramics may be the same as that of piezoelectric ceramics to be the piezoelectric body 11.

Here, as illustrated in FIGs. 12 and 13, in the other embodiment 5, the fixing material 60 fixes at least the extending portion 44 of the electrode plate 40 to the laminate body 10 while the first gap G₁ is maintained between the extending portion 44 and the laminate body 10. In other words, in the other embodiment 5, the piezoelectric element 1 has the first gap G₁ between the fixing material 60, the extending portion 44, and the laminate body 10.

This causes the extending portion 44 on the first gap G₁ to stretch in the laminate direction D, following the stretch of the laminate body 10 in the laminate direction D. Then, the stress generated at the end portion (near the one end 43a) of the bonding site between the electrode plate 40 and the electrical conductor layer 20 can be released to the interface between the fixing material 60 and the laminate body 10. Thus, the other embodiment 5 can disperse the stress generated at the end portion (near the one end 43a) of the bonding site between the electrode plate 40 and the electrical conductor layer 20 due to the stretch of the laminate body 10 in the laminate direction D. This can reduce the possibility that the electrode plate 40 separates from the electrical conductor layer 20.

### Another Embodiment 6

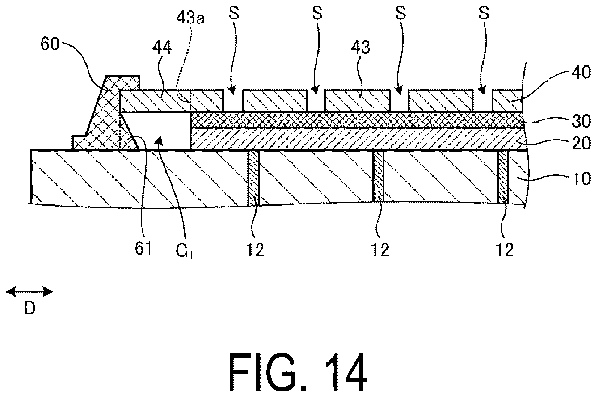

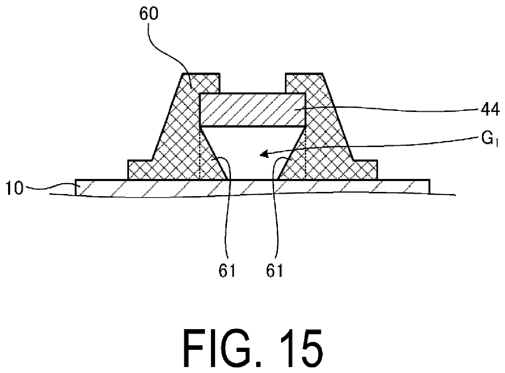

FIGs. 14 and 15 are cross-sectional views illustrating an example of the configuration of the electrode plate 40 and its surroundings according to the other embodiment 6. FIG. 14 corresponds to a cross-sectional view taken along line XII-XII illustrated in FIG. 11, and FIG. 15 corresponds to a cross-sectional view taken along line XIII-XIII illustrated in FIG. 11. In FIGs. 14 and 15, the illustration of the coating layer 50 is omitted for convenience of description.

In the other embodiment 6 illustrated in FIGs. 14 and 15, the configuration of the fixing material 60 is different from that of the other embodiment 5 described above. Specifically, in the other embodiment 6, the fixing material 60 has a protruding portion 61. The protruding portion 61 is positioned so as to project inward from the periphery of the extending portion 44 and is in contact with the laminate body 10. Here, "inward from the periphery of the extending portion 44" can be rephrased as a direction approaching the center axis of the extending portion 44 (electrode plate 40). The protruding portion 61 is an example of the first protruding portion.

Following the stretch of the laminate body 10 in the laminate direction D, a stress is generated at the end portion (near the one end 43a) of the bonding site between the electrode plate 40 and the electrical conductor layer 20. The other embodiment 6, by providing the protruding portion 61 at the fixing material 60, can more efficiently release this stress to the interface between the fixing material 60 and the laminate body 10. Thus, the other embodiment 6 can more efficiently disperse the stress generated at the end portion of the bonding site between the electrode plate 40 and the electrical conductor layer 20 due to the stretch of the laminate body 10 in the laminate direction D. This can further reduce the possibility that the electrode plate 40 separates from the electrical conductor layer 20.

### Another Embodiment 7

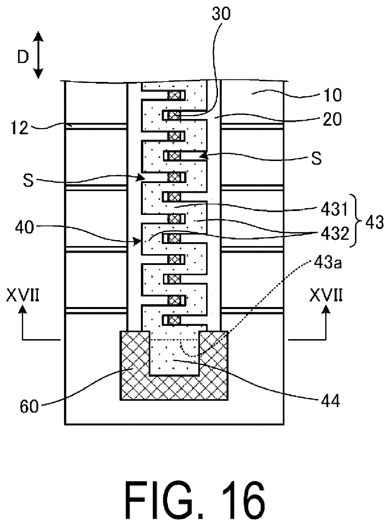

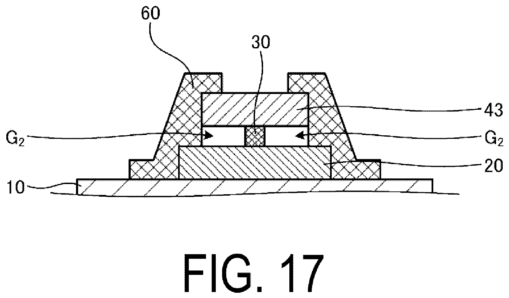

FIG. 16 is an enlarged plan view illustrating an example of the configuration of the electrode plate 40 and its surroundings according to the other embodiment 7. FIG. 17 is a cross-sectional view taken along line XVII-XVII illustrated in FIG. 16.

As illustrated in FIGs. 16 and 17, the other embodiment 7 fixes, by the fixing material 60, the body portion 43 and the electrical conductor layer 20 to the laminate body 10 at the one end of the electrical conductor layer 20 located on the one end 43a side of the body portion 43.

Following the stretch of the laminate body 10 in the laminate direction D, a stress is generated at the end portion (near the one end 43a) of the bonding site between the electrode plate 40 and the electrical conductor layer 20. Thus, the other embodiment 7 can more efficiently release this stress to the interface between the fixing material 60 and the laminate body 10. Thus, the other embodiment 7 can more efficiently disperse the stress generated at the end portion of the bonding site between the electrode plate 40 and the electrical conductor layer 20 due to the stretch of the laminate body 10 in the laminate direction D. This can further reduce the possibility that the electrode plate 40 separates from the electrical conductor layer 20.

### Another Embodiment 8

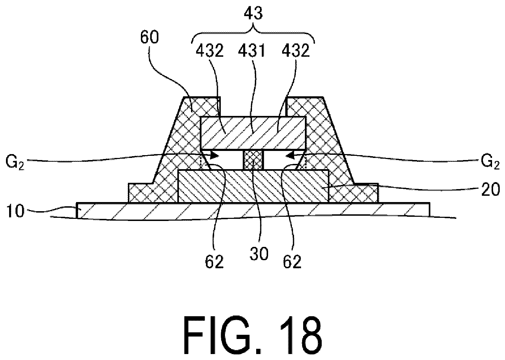

FIG. 18 is a cross-sectional view illustrating an example of the configuration of the electrode plate 40 and its surroundings according to the other embodiment 8. FIG. 18 corresponds to a cross-sectional view taken along line XVII-XVII illustrated in FIG. 16.

As described above, the body portion 43 includes the first portion 431 in contact with the bonding material 30, and a second portion 432 positioned on both sides of the first portion 431 in the width direction (i.e., the direction intersecting a laminate direction D) and facing the electrical conductor layer 20 without contacting the bonding material 30. The second portion 432 faces the electrical conductor layer 20 across a second gap G₂.

In the other embodiment 8 illustrated in FIG. 18, the configuration of the fixing material 60 is different from that of the other embodiment 7 described above. Specifically, in the other embodiment 8, the fixing material 60 has a protruding portion 62. The protruding portion 62 is positioned so as to project inward from the side of the second portion 432 and contacts the electrical conductor layer 20. Here, "inward from the side of the second portion 432" can be rephrased as a direction approaching the center axis of the extending portion 44 (electrode plate 40). The protruding portion 62 is an example of the second protruding portion.

In the other embodiment 8, by providing the protruding portion 62 at the fixing material 60, the adhesion force between the fixing material 60 and the electrical conductor layer 20 is improved compared with when the protruding portion 62 is not provided. Therefore, the adhesion force between the fixing material 60 and the laminate body 10 is improved. Therefore, the other embodiment 8 can reduce the possibility that the electrical conductor layer 20 separates from the laminate body 10.

### Another Embodiment 9

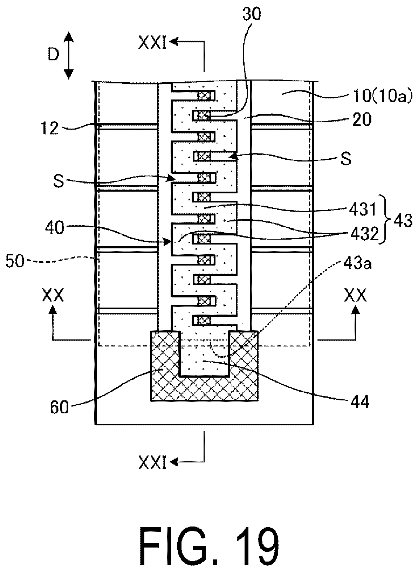

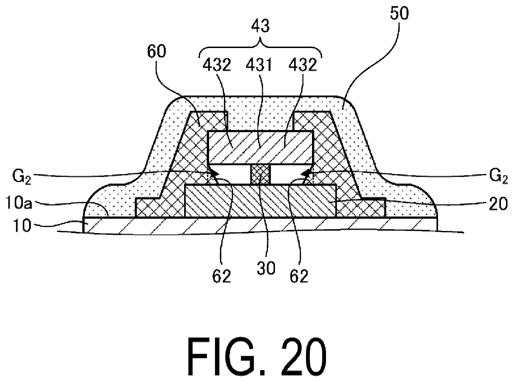

FIG. 19 is an enlarged plan view illustrating an example of the configuration of the electrode plate 40 and its surroundings according to the other embodiment 9. FIG. 20 is a cross-sectional view taken along line XX-XX illustrated in FIG. 19.

As illustrated in FIG. 19, in the other embodiment 9, the coating layer 50 covering the body portion 43 and the electrical conductor layer 20 is located on the side surface (example of a surface located along the laminate direction D of the laminate body 10) 10a of the laminate body 10. Although not illustrated in FIG. 19, the coating layer 50 covering the body portion 43 and the electrical conductor layer 20 is also located on the side surface (example of a surface located along the laminate direction D of the laminate body 10) 10b of the laminate body 10. By arranging the coating layer 50 on the side surfaces 10a and 10b, the body portion 43 and the electrical conductor layer 20 can be protected.

The coating layer 50 is made of, for example, an insulator. For example, fluorine-based resin, silicone resin, epoxy resin, nylon resin, or the like are used as the insulator to be the coating layer 50.

In the other embodiment 9, as illustrated in FIGs. 19 and 20, the end portion of the coating layer 50 covers the end portion of the fixing material 60 located on the one end 43a side of the body portion 43.

Following the stretch of the laminate body 10 in the laminate direction D, a stress is generated at the end portion (near the one end 43a) of the bonding site between the electrode plate 40 and the electrical conductor layer 20. Thus, the other embodiment 9 can thus more efficiently release this stress to the interface between the fixing material 60 and the laminate body 10 and the interface between the coating layer 50 and the laminate body 10. Thus, the other embodiment 9 can more efficiently disperse the stress generated at the end portion of the bonding site between the electrode plate 40 and the electrical conductor layer 20 due to the stretch of the laminate body 10 in the laminate direction D. This can further reduce the possibility that the electrode plate 40 separates from the electrical conductor layer 20.

### Another Embodiment 10

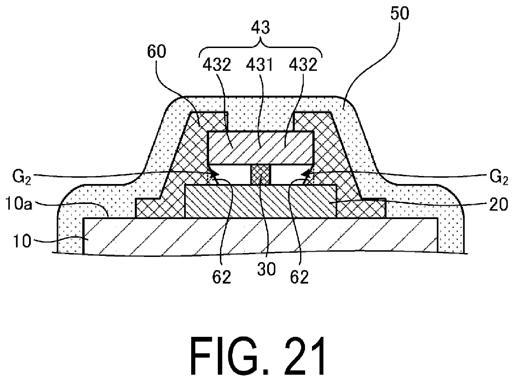

FIG. 21 is a cross-sectional view illustrating an example of the configuration of the electrode plate 40 and its surroundings according to another embodiment 10. FIG. 21 corresponds to a cross-sectional view taken along line XXI-XXI illustrated in FIG. 19.

In the other embodiment 10 illustrated in FIG. 21, the configuration of the coating layer 50 is different from that of the other embodiment 9 described above. Specifically, in the other embodiment 10, the coating layer 50 is positioned on the entire circumference of the side surface including the side surface 10a of the laminate body 10. That is, the coating layer 50 is positioned not only on the side surfaces 10a and 10b of the laminate body 10 but also on the side surfaces 10c (see FIG. 1) and 10d (see FIG. 1) that are located between the side surfaces 10a and 10b.

This allows the other embodiment 10 to disperse the stress generated in the coating layer 50 to the entire periphery of the side surfaces of the laminate body 10, following the stretch of the laminate body 10 in the laminate direction D.

### Another Embodiment 11

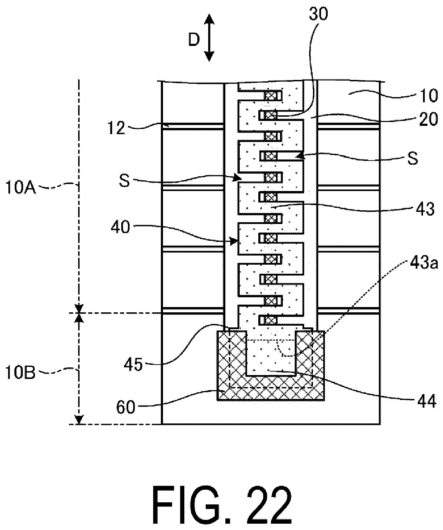

FIG. 22 is an enlarged plan view illustrating an example of a configuration of the electrode plate 40 and its surroundings according to another embodiment 11. As described above, the laminate body 10 is composed of an active section 10A composed by alternately laminating a plurality of piezoelectric bodies 11 and internal electrodes 12 and an inactive section 10B that is arranged at both ends in the laminate direction D in the active section, includes the piezoelectric bodies 11, and does not include the internal electrodes 12.

As illustrated in FIG. 22, in the other embodiment 11, the electrode plate 40 has a large width portion 45 that is larger in width than other portions at a position overlapping the inactive section 10B in a plan view at least in the extending portion 44. In the other embodiment 11, the fixing material 60 may fix the large width portion 45 to the laminate body 10.

Following the stretch of the laminate body 10 in the laminate direction D, a stress is generated at the end portion (near the one end 43a) of the bonding site between the electrode plate 40 and the electrical conductor layer 20. Thus, the other embodiment 11 can more efficiently release this stress to the interface between the fixing material 60 and the laminate body 10. Thus, the other embodiment 11 can more efficiently disperse the stress generated at the end portion of the bonding site between the electrode plate 40 and the electrical conductor layer 20 due to the stretch of the laminate body 10 in the laminate direction D. This can further reduce the possibility that the electrode plate 40 separates from the electrical conductor layer 20.

### Another Embodiment 12

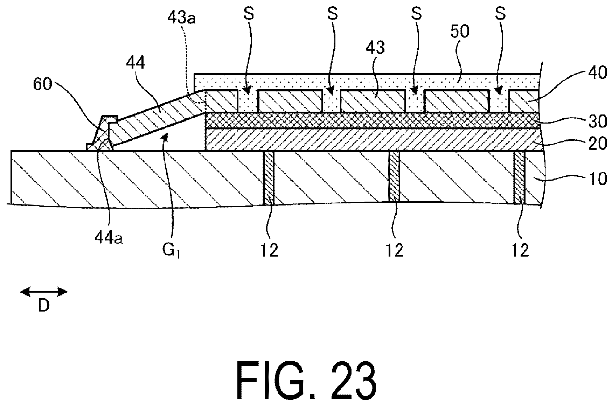

FIG. 23 is a cross-sectional view illustrating an example of the configuration of the electrode plate 40 and its surroundings according to another embodiment 12. FIG. 23 corresponds to a cross-sectional view taken along line XXI-XXI illustrated in FIG. 19.

In the other embodiment 12 illustrated in FIG. 23, the extending portion 44 is inclined such that the distance between the extending portion 44 and the laminate body 10 becomes narrow toward a front end 44a of the extending portion 44. In other words, the extending portion 44 is inclined downward toward the front end 44a of the extending portion 44.

As a result, in the other embodiment 12, a part of the fixing material 60 in the uncured state is appropriately filled in the gap between the front end 44a of the extending portion 44 and the laminate body 10, so that the adhesion strength, after the fixing material 60 is cured, between the front end 44a of the extending portion 44 and the laminate body 10, can be improved.

### Others

In FIGs. 9 and 10, the shape of the through hole H is rectangular in a plan view but may be rounded near the end portion in the width direction of the electrode plate 40. At this time, the possibility can be reduced that the stress concentrates on the corner portion and cracks are generated during the stretch.

### Method of Manufacturing Piezoelectric Element

A method of manufacturing an example of the piezoelectric element 1 according to the present embodiment will be described. A ceramic green sheet to be a piezoelectric body layer (piezoelectric body 11) is produced. Specifically, a ceramic slurry is produced by mixing calcined powder of piezoelectric ceramics, a binder having an organic polymer such as acrylic or butyral, and a plasticizer. A ceramic green sheet is produced from the ceramic slurry by using a tape molding method such as a well-known doctor blade method and a calender roll method. As the piezoelectric ceramics, any material having piezoelectric properties may be used. For example, a perovskite oxide having Pb ZrO₃-PbTiO₃, or the like can be used. As the plasticizer, dibutyl phthalate (DBP), dioctyl phthalate (DOP), or the like can be used.

An electrically conductive paste as the internal electrode 12 is produced. Specifically, an electrically conductive paste is produced by adding and mixing a binder and a plasticizer to metal powder of silver-palladium alloy. The electrically conductive paste is printed on the ceramic green sheet by screen printing. A plurality of ceramic green sheets printed with the electrically conductive paste are stacked, and a plurality of ceramic green sheets not printed with the electrically conductive paste are stacked on both ends in the laminate direction to obtain a multilayer molded body. The laminate molded body is subjected to debinding treatment at a predetermined temperature and is then baked at 900 to 1200 °C to obtain the laminate body 10.

Subsequently, the electrically conductive paste consisting of silver and glass is coated on the side surface of the laminate body 10 and is baked to form the electrical conductor layer 20. The electrically conductive paste is made by adding and mixing a binder, plasticizer, glass powder, or the like to a metal powder consisting mainly of silver. Printing the electrically conductive paste on the side surface of the laminate body 10 by screen printing or the like and baking it at 600 to 800 °C can form the electrical conductor layer 20.

The bonding material 30 is applied to the upper surface of the electrical conductor layer 20, and an electrode plate 40 is stuck thereon, and then the bonding material 30 is dried at a temperature of 100 to 140 °C and is then cured at a temperature of 180 to 220 °C to fix the electrode plate 40.

Then, the coating layer 50 is coated on the laminate body 10 by a general coating method such as dipping, defoaming treatment is performed, and the coating layer 50 is then cured. This may cause microscopic void of 0.1 µm or less to be dispersed in the coating layer 50 but forms no gap G. Then, the gap G can also be formed by using a resin with high viscosity as the coating layer 50 and applying the resin to a predetermined position by screen printing. Note that for example, the gap G can also be formed by the following method as another method.

The photosensitive coating layer 50 is applied to the laminate body 10. Then, the gap G is provided between the electrode plate 40 and the electrical conductor layer 20, and the gap G is irradiated with light and cured before the coating layer 50 flows into the gap G. The piezoelectric element 1 of the present example is produced by the above method.

A method of applying the coating layer 50 twice may also be used. Specifically, the coating layer 50 is applied before the bonding material 30 and the electrode plate 40 are fixed. Then, after exposing the electrical conductor layer 20 by plasma etching or blast treatment to the place where the electrode plate 40 is to be fixed, the bonding material 30 and the electrode plate 40 are fixed, and the coating layer 50 is applied again on the electrode plate 40 to form the gap G.

The electrode plate 40 having the projecting portion 41 (42) described in FIGs. 7 and 8 is fixed to the laminate body 10 to reduce the distance between the projecting portion 41 (42) and the electrical conductor layer 20, and the coating layer 50 is applied by screen printing. This causes the coating layer 50 to less likely to flow into the projecting portion 41 (42), and in this state, the coating layer 50 is hardened to form the gap G. The piezoelectric element 1 of the present example is produced by the above method.

As described above, the piezoelectric element (e.g., piezoelectric element 1) according to the embodiments includes the laminate body (e.g., laminate body 10), the electrical conductor layer (e.g., electrical conductor layer 20), the electrode plate (e.g., electrode plate 40), and the coating layer (e.g., coating layer 50). The laminate body includes a plurality of the piezoelectric bodies (e.g., piezoelectric body 11) and a plurality of internal electrodes (e.g., internal electrode 12) laminated. The electrical conductor layer is connected to the internal electrodes and is positioned along the laminate direction (e.g., laminate direction D) of the laminate body. The electrode plate is bonded to the electrical conductor layer via the electrically conductive bonding material (e.g., bonding material 30) and is positioned along the laminate direction of the laminate body. The coating layer covers the electrical conductor layer and the electrode plate. The electrode plate includes a plurality of slits (e.g., slit S) extending in the direction (e.g., width direction) intersecting the laminate direction. The piezoelectric element has a first gap (e.g., the gap G) between the electrode plate, the electrical conductor layer, and the bonding material. This can reduce the possibility of separation of the electrode plate covered with the coating layer.

Note that with respect to the above embodiments, the following additional notes are disclosed.

### Supplementary Note 1

A piezoelectric element, including:
a laminate body with a plurality of piezoelectric bodies and a plurality of internal electrodes laminated;
an electrical conductor layer connected to the plurality of internal electrodes and positioned along a laminate direction of the laminate body;
an electrode plate bonded to the electrical conductor layer via a bonding material having electrical conductivity and positioned along the laminate direction of the laminate body; and
a coating layer covering the electrical conductor layer and the electrode plate, wherein the electrode plate includes a plurality of slits extending in a direction intersecting the laminate direction, and
the piezoelectric element includes a first gap between the electrode plate, the electrical conductor layer, and the bonding material.

### Supplementary Note 2

The piezoelectric element according to Supplementary Note 1, wherein the coating layer includes a first protruding portion protruding inward from an end portion of the electrode plate in the direction intersecting the laminate direction and contacting the electrical conductor layer.

### Supplementary Note 3

The piezoelectric element according to Supplementary Note 1 or 2, wherein the electrode plate includes a first projecting portion projecting in a thickness direction of the electrode plate at a periphery of an end portion of the electrode plate in the direction intersecting the laminate direction.

### Supplementary Note 4

The piezoelectric element according to Supplementary Note 3, wherein the first projecting portion extends along the laminate direction of the laminate body.

### Supplementary Note 5

The piezoelectric element according to any one of Supplementary Notes 1 to 4, wherein the coating layer includes a second protruding portion protruding inward from inner wall surfaces of the slits in the electrode plate and contacting the electrical conductor layer.

### Supplementary Note 6

The piezoelectric element according to any one of Supplementary Notes 1 to 5, wherein the electrode plate includes a second projecting portion projecting in a thickness direction of the electrode plate at the periphery of the slits.

### Supplementary Note 7

The piezoelectric element according to Supplementary Note 6, wherein the second projecting portion extends along a longitudinal direction of the slits.

### Supplementary Note 8

The piezoelectric element according to any one of Supplementary Notes 1 to 7, wherein a gap between one end portion of the electrode plate positioned outside from the bonding material in a width direction of the electrode plate in a plan view and the electrical conductor layer is separated from a gap between the other end portion of the electrode plate and the electrical conductor layer.

### Supplementary Note 9

The piezoelectric element according to any one of Supplementary Notes 1 to 8, wherein the electrode plate includes a through hole positioned between the slits adjacent to each other.

Further effects and other embodiments can be easily derived by those skilled in the art. Thus, the broader aspects of the present invention are not limited to the specific details and representative embodiments represented and described above. Accordingly, various modifications may be made without departing from the spirit or scope of the general inventive concept as defined by the appended claims and equivalents thereof.

### REFERENCE SIGNS

1 Piezoelectric element
10 Laminate body
10a to 10d Side surface
10e Base end portion
10f Front end portion
11 Piezoelectric body
12 Internal electrode
12a First electrode
12b Second electrode
13 Planned breaking layer
20, 20A, 20B Electrical conductor layer
30 Bonding material
40, 40A, 40B Electrode plate
41, 42 Projecting portion
50 Coating layer
51, 52 Protruding portion
D Laminate direction
G Gap
H Through hole
S Slit

## Claims

1. A piezoelectric element, comprising:
a laminate body with a plurality of piezoelectric bodies and a plurality of internal electrodes laminated;
an electrical conductor layer connected to the plurality of internal electrodes and positioned along a laminate direction of the laminate body;
an electrode plate bonded to the electrical conductor layer via a bonding material having electrical conductivity and positioned along the laminate direction of the laminate body; and
a coating layer covering the electrical conductor layer and the electrode plate, wherein
the electrode plate comprises a plurality of slits extending in a direction intersecting the laminate direction, and
the piezoelectric element comprises a first gap between the electrode plate, the electrical conductor layer, and the bonding material.

2. The piezoelectric element according to claim 1, wherein the coating layer comprises a first protruding portion protruding inward from an end portion of the electrode plate in the direction intersecting the laminate direction and contacting the electrical conductor layer.

3. The piezoelectric element according to claim 1 or 2, wherein the electrode plate comprises a first projecting portion projecting in a thickness direction of the electrode plate at a periphery of an end portion of the electrode plate in the direction intersecting the laminate direction.

4. The piezoelectric element according to claim 3, wherein the first projecting portion extends along the laminate direction of the laminate body.

5. The piezoelectric element according to any one of claims 1 to 4, wherein the coating layer comprises a second protruding portion protruding inward from inner wall surfaces of the slits in the electrode plate and contacting the electrical conductor layer.

6. The piezoelectric element according to any one of claims 1 to 5, wherein the electrode plate comprises a second projecting portion projecting in a thickness direction of the electrode plate at the periphery of the slits.

7. The piezoelectric element according to claim 6, wherein the second projecting portion extends along a longitudinal direction of the slits.

8. The piezoelectric element according to any one of claims 1 to 7, wherein a gap between one end portion of the electrode plate positioned outside from the bonding material in a width direction of the electrode plate in a plan view and the electrical conductor layer is separated from a gap between the other end portion of the electrode plate and the electrical conductor layer.

9. The piezoelectric element according to any one of claims 1 to 8, wherein the electrode plate comprises a through hole positioned between the slits adjacent to each other.
